# FASCICULE DE BREVET EUROPEEN

(11) **EP 3 145 081 B1**
(45) Date de publication et mention de la délivrance du brevet: **20.11.2019**
(21) Numéro de dépôt: 16185246.2
(22) Date de dépôt: 23.08.2016
(51) Int. Cl.: H03H 7/42

(54) **FILTRE ÉLECTRIQUE**
ELEKTRISCHER FILTER
ELECTRIC FILTER

(30) Priorité: 15.09.2015 FR 1558602
(43) Date de publication de la demande: 22.03.2017
(73) Titulaire: VALEO SYSTEMES THERMIQUES, 78320 Le Mesnil Saint-Denis (FR)
(72) Inventeur: ROUSSEIL, Xavier, 92170 Vanves (FR); FOURNIER, Jonathan, 78160 Le Perray-en-Yvelines (FR); GOUMAIN, Xavier, 78180 Montigny-le-Bretonneux (FR)
(74) Mandataire: Metz, Gaëlle

(56) Documents cités:
- EP-A1- 2 625 997
- US-A- 4 622 526
- US-A1- 2007 188 265
- US-A1- 2014 252 896
- "FOCUS ON: MAINS-NOISE SUPPRESSION. DESIGN AND FUNCTION OF MAINS FILTERS", ELEKTOR ELECTRONICS, ELEKTOR ELECTRONICS, GB, vol. 23, no. 256, 1 June 1997 (1997-06-01) , pages 26-29, XP000724200, ISSN: 0268-4519

## Description

La présente invention concerne un filtre électrique, un équipement électrique qui est pourvu d'un tel filtre et un véhicule qui est équipé d'un tel équipement.

Les normes de compatibilité électromagnétique, désignées par l'acronyme CEM, imposent des limitations sur les courants parasites qui sont produits par les appareils électriques et transmis à la source de tension électrique qui alimente chaque appareil. Ces courants parasites sont souvent désignés par émissions conduites. En effet, de nombreux appareils électriques, notamment ceux dont le fonctionnement utilise des commutations à haute fréquence, par exemple les moteurs sans balais, également appelés moteurs à commutation électronique ou « brushless » en anglais, produisent des courants parasites qui peuvent endommager d'autres appareils qui sont connectés à la même source de tension. Dans le cas d'équipements électriques qui sont montés dans des véhicules, ces courants parasites sont particulièrement gênants dans la bande de fréquence comprise entre 76 MHz (mégahertz) et 108 MHz, car cette bande correspond à la réception FM.

Ces exigences concernent notamment le courant de mode commun qui est transmis par un appareil électrique à la source de tension électrique utilisée pour l'alimenter en énergie. De façon connue, le courant de mode commun désigne un courant électrique qui est retransmis par l'appareil à la source de tension avec des intensités qui sont identiques dans toutes les liaisons électriques qui relient la source à l'appareil, et avec un sens d'écoulement de courant qui est commun à toutes ces liaisons : de l'appareil en direction de la source de tension.

La norme BMW Group Standard GS 95002-2 : « Electromagnetic Compatibility (EMC) - requirements and tests on components up to 60 V nominal voltage » impose que la partie du courant de mode commun qui est conduite par chaque liaison électrique, appelée courant élémentaire de mode commun dans la présente description, produise une tension qui est inférieure à 33 dBµV quand sa fréquence est comprise entre 3,85 MHz et 26,1 MHz, et lorsqu'un réseau de stabilisation d'impédance de ligne (RSIL) est inséré entre l'équipement électrique et la source de tension, dans une résistance de connexion à la masse qui est égale à 50 Ω (ohm). Lorsque la fréquence du courant de mode commun est comprise entre 76 MHz et 108 MHz, la tension électrique dans la résistance de connexion à la masse doit être inférieure à 12 dBµV dans les mêmes conditions de mesure.

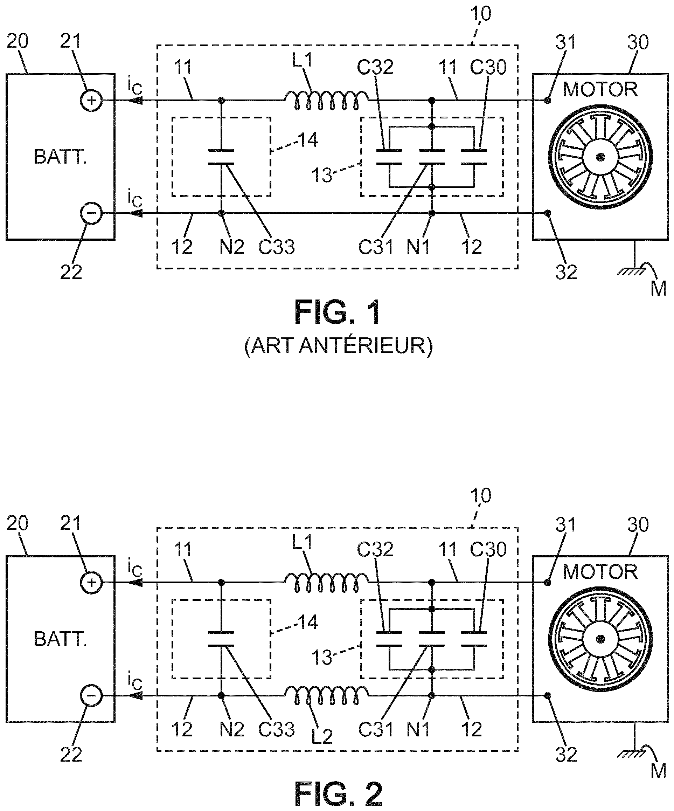

Pour tenter de satisfaire ces exigences CEM, il est connu de munir l'appareil électrique susceptible de produire le courant de mode commun, d'un filtre électrique qui est connecté entre la source de tension et l'appareil. En référence à la figure 1, un tel filtre électrique 10 peut comprendre :
- une première liaison électrique 11 qui est destinée à relier une première borne de sortie 21 de la source 20 à une première borne d'alimentation électrique 31 de l'appareil 30, cette première liaison 11 comprenant une première bobine L1 ;
- une seconde liaison électrique 12 qui est destinée à relier une seconde borne de sortie 22 de la source 20 à une seconde borne d'alimentation électrique 32 de l'appareil 30 ;
- un premier ensemble capacitif 13 qui peut comprendre au moins un condensateur C30-C32, ce premier ensemble capacitif 13 étant connecté d'une part à la première liaison 11 entre la première bobine L1 et la première borne d'alimentation électrique 31 de l'appareil 30, et connecté d'autre part à la seconde liaison 12 par un premier nœud N1 ; et
- un second ensemble capacitif 14 qui peut comprendre au moins un autre condensateur C33, ce second ensemble capacitif 14 étant connecté d'une part à la première liaison 11 entre la première borne de sortie 21 de la source 20 et la première bobine L1, et connecté d'autre part à la seconde liaison 12 par un second nœud N2, le premier nœud N1 étant situé dans la seconde liaison électrique 12 entre le second nœud N2 et la seconde borne d'alimentation électrique 32 de l'appareil 30.

Un tel filtre électrique est couramment appelé filtre en PI. Toutefois, lorsque le courant de mode commun qui est produit par l'appareil électrique présente des composantes spectrales significatives au-dessus de 76 MHz, l'utilisation d'un tel filtre en PI peut être insuffisante pour respecter les exigences indiquées ci-dessus. Autrement dit, pour des fréquences supérieures à 76 MHz, la tension qui est générée dans la résistance de connexion à la masse de 50 Ω en insérant un réseau de stabilisation d'impédance de ligne sur la liaison qui fait l'objet de la mesure, entre l'appareil et la source de tension, peut être supérieure à 12 dBµV.

US 4622526 A1 décrit un filtre de ligne électrique formé sur une carte de circuit imprimé présentant une zone de mise à la terre étendue et sur lequel sont montés des condensateurs parallèles, une paire d'inductances de ligne et une résistance parallèle. Chacun des inducteurs est formé de bobines à plusieurs sections enroulées sur des bobines en plastique et qui peuvent être bobinées à la machine. Les deux inducteurs enroulés sont ensuite montés sur des noyaux rectangulaires en forme de U-U ou U-I pour former les inducteurs de ligne. Au moins deux des condensateurs sont de forme rectangulaire et sont montés aux extrémités opposées des inductances de ligne.

US 2007/0188265 A1 concerne un enroulement couplé apte à annuler l'inductance parasite des premier et second condensateurs de mode commun et différentiels dans un filtre EMI comportant des condensateurs de mode commun et un condensateur différentiel.

US 2014/0252896 A1 décrit un filtre EMI. Le filtre comprend une entrée, une sortie, des premier et second condensateurs X côté ligne et un condensateur Y côté ligne. L'entrée comprend des première et seconde bornes d'entrée. La sortie comprend des première et seconde bornes de sortie. Un premier chemin conducteur est défini entre la première borne d'entrée et la première borne de sortie. Un deuxième chemin conducteur est défini entre la deuxième borne d'entrée et la deuxième borne de sortie. Le premier condensateur X côté ligne est couplé entre le premier chemin conducteur et le deuxième chemin conducteur. Le deuxième condensateur X côté ligne est couplé entre le premier chemin conducteur et le deuxième chemin conducteur en série avec le premier condensateur X côté ligne. Le deuxième condensateur X côté ligne est couplé au premier condensateur X côté ligne en un point commun. Une première extrémité du condensateur Y côté ligne est couplée au point commun.

EP 2625997 A1 divulgue un lave-vaisselle qui comprend une base qui supporte une cuve de lavage en matériau métallique, la base étant en matériau électriquement non conducteur et présentant une pluralité de parois périphériques, qui définissent un espace pour loger une pluralité de charges électriques pouvant être alimentées via un câble électrique pour la connexion à un secteur électrique. Un dispositif de filtrage comprenant un filtre anti-bruit doté d'une connexion de mise à la terre est fourni en amont de la pluralité de charges électriques. La connexion de mise à la terre du filtre anti-bruit comprend un élément de contact électrique comprenant une bande métallique ayant une partie de contact intercalée entre la cuve et la base.

La publication "Focus on: Mains-Noise Suppression. Design and Function of Mains Filters", Elektor Electronics, GB, vol. 23, no. 256, 1 juin 1997 (1997-06-01), pages 26-29, ISSN: 0268-4519 décrit un filtre EMI comportant des bobines couplées et condensateurs de mode common.

A partir de cette situation, un but de la présente invention consiste à réduire encore le courant de mode commun pour les fréquences qui sont supérieures à 76 MHz. Cette réduction est recherchée de préférence pour que la tension qui est produite par ce courant de mode commun dans une résistance de connexion à la masse de 50 Ω, soit inférieure à 12 dBµV en utilisant un réseau de stabilisation d'impédance de ligne entre l'équipement électrique et la source de tension électrique.

D'autres buts de l'invention sont de proposer un nouveau filtre électrique apte à réduire le courant de mode commun, qui soit peu encombrant, peu onéreux, et facile à mettre en œuvre à partir d'un filtre en PI tel que rappelé ci-dessus.

Les buts mentionnés ci-dessus sont résolus avec un équipement électrique selon la revendication 1. Les caractéristiques optionnelles de l'équipement sont définies dans les revendications dépendantes.

Pour cela, un premier aspect de l'invention propose de modifier la seconde liaison du filtre en PI pour que cette seconde liaison comprenne au moins une seconde bobine qui est située entre le premier nœud et le second nœud.

Grâce à une telle seconde bobine qui est ajoutée au filtre en PI, l'exigence de tension inférieure à 12 dBµV associée au courant de mode commun dans les conditions de mesure qui ont été indiquées plus haut, peut être satisfaite pour un nombre supérieur d'appareils électriques.

En outre, un tel ajout de seconde bobine dans le filtre en PI crée peu d'encombrement supplémentaire est peu onéreux et facile à mettre en œuvre.

Dans l'invention, les première et seconde bobines sont positionnées l'une par rapport à l'autre pour produire une interaction magnétique entre elles. Les bobines ont des sens d'enroulement respectifs tels que des courants électriques égaux et variables qui entrent dans la source électrique par les première et seconde bornes de sortie, un courant séparément par chaque borne de sortie, produisent dans chacune des bobines une contribution de tension par induction mutuelle et une contribution de tension par auto-induction qui ont un même signe pour cette bobine, en moyenne pendant une durée d'utilisation du filtre. L'efficacité du filtre électrique peut ainsi être encore améliorée, notamment pour des fréquences qui sont supérieures à 76 MHz. En particulier, les première et seconde bobines peuvent être couplées, et l'une de ces bobines peut être bobinée dans le sens horaire alors que l'autre peut être bobinée dans le sens antihoraire.

Un écart entre la valeur d'inductance de la première bobine et celle de la seconde bobine est inférieur ou égal à 20 %. Une telle proximité de valeur d'inductance est en outre favorable pour réduire un courant de mode différentiel qui est produit par l'appareil électrique à travers la source de tension électrique.

La première bobine a une valeur d'inductance qui est comprise entre 0,1 et 1µH. Indépendamment ou en combinaison, la seconde bobine peut aussi avoir une valeur d'inductance qui est comprise entre 0,1 et 1µH. De façon générale, on entend par valeur d'inductance d'une bobine sa valeur d'auto-inductance.

D'autre part, le premier ensemble capacitif peut comprendre au moins un condensateur, ainsi que le second ensemble capacitif.

Le premier ensemble capacitif peut avoir une valeur de capacité qui est comprise entre 300 et 3000 µF. Simultanément, le second ensemble capacitif peut avoir une valeur de capacité qui est comprise entre 100 et 1000 µF.

L'invention propose un équipement électrique qui comprend un appareil électrique à au moins deux bornes d'alimentation électrique, et un filtre électrique qui est conforme au premier aspect de l'invention. Les première et seconde liaisons électriques du filtre sont alors connectées une-à-une aux deux bornes d'alimentation électrique de l'appareil de sorte que le premier ensemble capacitif soit connecté électriquement en parallèle avec l'appareil entre les deux bornes d'alimentation électrique de ce dernier. Dans un tel équipement électrique, l'appareil électrique comprend un moteur sans balais, ou « brushless ».

L'appareil électrique peut comprendre un groupe moto-ventilateur.

L'équipement électrique auquel est appliquée l'invention peut former un système de chauffage, ventilation et conditionnement d'air pour un habitacle de véhicule. Dans ce cas, l'appareil électrique comprend un moteur qui est agencé pour la ventilation de l'habitacle.

De préférence, les première et seconde bobines, et les premier et second ensembles capacitifs peuvent être sélectionnés de sorte qu'un courant élémentaire de mode commun qui est produit par l'équipement et transmis à la source de tension électrique par l'une ou l'autre des bornes de sortie de celle-ci, dite borne de test, produise une tension qui est inférieure à 12 dBµV à une fréquence de 80 MHz, lorsqu'un réseau de stabilisation d'impédance de ligne est inséré entre la borne de test et celle de la première ou seconde liaison du filtre à laquelle est connectée la borne de test, et lorsqu'une résistance égale à 50 Ω est connectée entre le réseau de stabilisation d'impédance de ligne et la borne de masse de l'appareil électrique, la tension étant mesurée entre deux extrémités la résistance.

Un aspect non-revendiqué de l'invention propose un véhicule qui comprend une batterie à au moins deux bornes de sortie, et un équipement électrique qui est conforme à l'invention. Les première et seconde liaisons du filtre sont alors connectées une-à-une aux deux bornes de sortie de la batterie de sorte que le second ensemble capacitif soit connecté électriquement en parallèle avec la batterie entre les deux bornes de sortie de cette dernière. En particulier, l'équipement électrique du véhicule, auquel est appliquée l'invention, peut comprendre un système de chauffage, ventilation et conditionnement d'air pour l'habitacle du véhicule. Dans ce cas, l'appareil électrique peut comprendre un moteur sans balais qui est agencé pour la ventilation de l'habitacle.

D'autres particularités et avantages de la présente invention apparaîtront dans la description ci-après d'exemples de réalisation non limitatifs, en référence aux dessins annexés, dans lesquels :
- la figure 1, déjà décrite, est un schéma électrique de filtre tel que connu avant la présente invention ;
- la figure 2 correspond à la figure 1 pour un filtre électrique conforme à la présente invention ;
- les figures 3a et 3b représentent deux montages de test qui sont utilisés pour caractériser un courant de mode commun produit par un équipement électrique muni du filtre de la figure 2 ; et
- les figures 4a et 4b sont deux diagrammes spectraux de caractérisation du courant de mode commun, respectivement pour les montages de test des figures 3a et 3b.

Des références identiques qui sont indiquées dans les figures 1 à 3 désignent des éléments identiques ou qui ont des fonctions identiques.

A partir de la figure 1, le filtre de l'invention, qui est encore référencé 10, est obtenu en ajoutant une bobine L2 telle que représentée sur la figure 2. La bobine L2 est située dans la liaison électrique 12 entre les nœuds N1 et N2. Les condensateurs C30-C32, au nombre de trois à titre d'exemple, qui sont connectés en parallèle les uns aux autres, entre la première liaison 11 et le nœud N1 dans la seconde liaison 12, forment le premier ensemble capacitif 13. Le condensateur C32 qui est connecté entre la première liaison 11 et le nœud N2 dans la seconde liaison 12, forme le second ensemble capacitif 14. Le long de la première liaison 11, la bobine L1 est située entre la connexion du premier ensemble capacitif 13, du côté de l'appareil électrique 30, et la connexion du second ensemble capacitif 14, du côté de la source électrique 20.

La source électrique 20 peut être une batterie notée BATT., par exemple une batterie de véhicule automobile.

L'appareil électrique 30 peut être un moteur noté MOTOR, notamment du type sans balais, ou un onduleur pour moteur. Par exemple, il peut s'agir d'un moteur de ventilation de l'habitacle du véhicule, faisant partie d'un système de chauffage, ventilation et conditionnement d'air. M désigne une borne de masse de l'appareil électrique 30.

Le filtre 10 de l'invention, comprenant la seconde bobine L2, et l'appareil électrique 30 forment conjointement un équipement électrique conforme à l'invention.

Le filtre électrique 10 conforme à l'invention peut être réalisé sur une carte de circuit imprimé (PCB pour « printed circuit board » en anglais), avec des composants discrets qui sont rapportés sur cette carte. Par exemple, chacun des condensateurs C30-C33 peut avoir une valeur de capacité égale à 330 µF (microfarad), formant une valeur totale de capacité égale à 990 µF pour l'ensemble capacitif 13, et chacune des bobines L1 et L2 peut avoir une valeur d'inductance égale à 0,43 µH (microhenry).

Le courant de mode commun est constitué par deux courants égaux, qui sont appelés courants élémentaires de mode commun et notés i_{C} sur les figures 1 à 3, et qui s'écoulent vers la source de tension 20 séparément par les bornes de sortie 21 et 22, respectivement à partir des liaisons 11 et 12. Le courant de mode commun peut être rebouclé par la borne de masse M par effet capacitif.

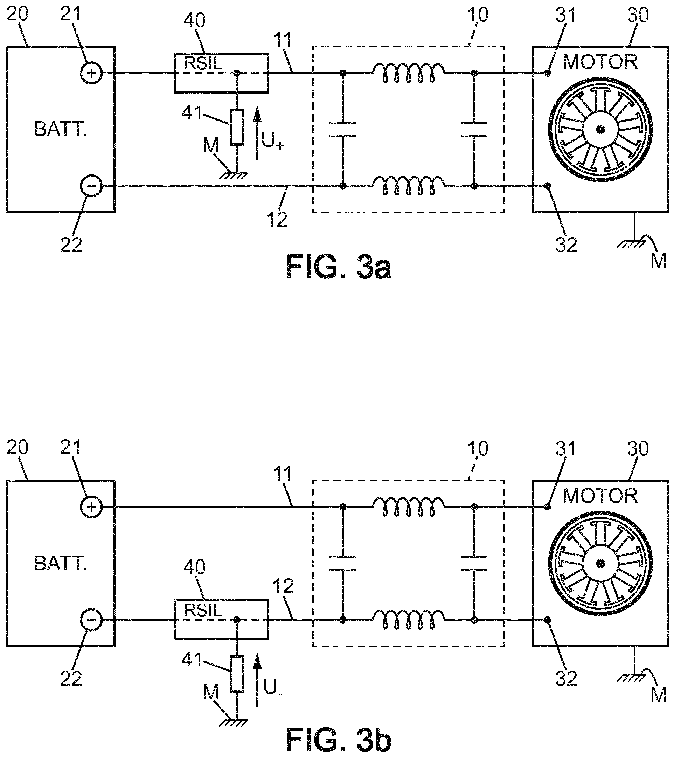

La figure 3a illustre une méthode de caractérisation du courant de mode commun des émissions conduites, par caractérisation du courant élémentaire de mode commun i_{C} qui est transmis par la liaison 11 à la borne de sortie 21 de la source 20. Pour cela, un réseau de stabilisation d'impédance de ligne 40, noté RSIL, est inséré entre le filtre 10 et la borne de sortie 21, sur la liaison 11. Le réseau 40 est d'un modèle disponible commercialement, et son utilisation est supposée connue de l'Homme du métier. Le réseau 40 est connecté par ailleurs à la borne de masse M de l'appareil 30 par une résistance 41 de 50 Ω (ohm). La tension électrique notée U₊, qui existe alors dans la résistance 41 lorsque l'appareil 30 est alimenté en énergie électrique par la source 20, est analysée en fonction de la fréquence du courant de mode commun.

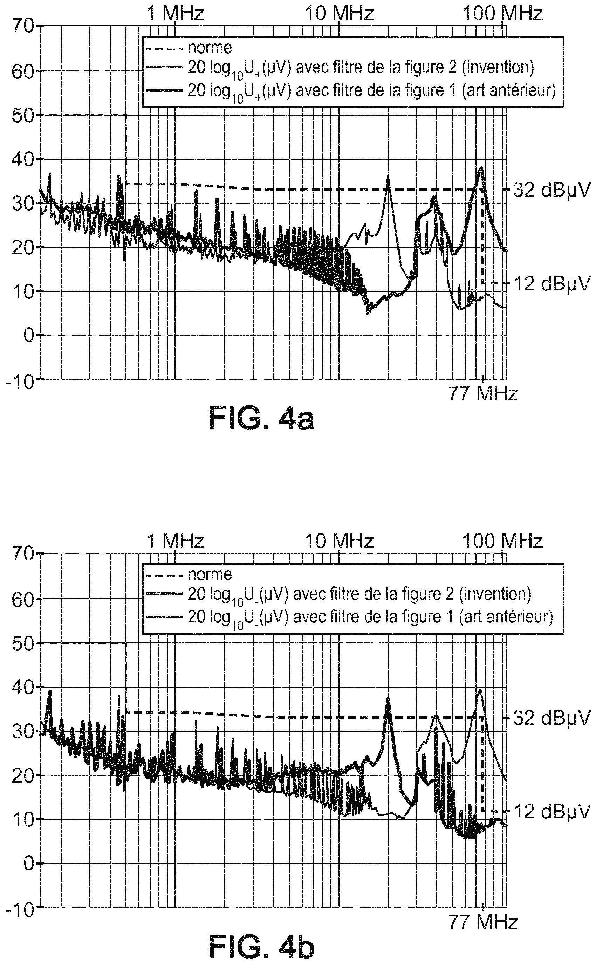

Le diagramme de la figure 4a montre le résultat d'une telle analyse. L'axe horizontal repère les valeurs de la fréquence exprimée en MHz, sur une échelle logarithmique, et l'axe vertical repère les valeurs de 20· log₁₀(U₊), en décibels lorsque U₊ est exprimée en microvolts (µV). Dans ce diagramme, le trait interrompu représente la limite maximale qui est autorisée par la norme BMW Group Standard GS 95002-2 : "Electromagnetic Compatibility (EMC) - requirements and tests on components up to 60 V nominal voltage", pour la tension U₊ représentative du courant de mode commun. La courbe en trait continu fin de la figure 4a est la caractéristique spectrale de la tension U₊ lorsque l'appareil 30 est pourvu du filtre 10 conforme à l'invention, tel que représenté sur la figure 2 et avec les valeurs numériques de capacités et d'inductances qui ont été indiquées plus haut. La caractéristique de la tension U₊ est située en dessous de la limite prescrite par la norme BMW Group Standard GS 95002-2 lorsque la fréquence est supérieure à 22 MHz. En outre, le dépassement de la tension U₊ au-dessus de la limite de la norme BMW Group Standard GS 95002-2 à la fréquence de 20 MHz, n'est que de 2 dBµV et peut être supprimé facilement par un filtre additionnel.

Pour comparaison, le diagramme de la figure 4a montre aussi (courbe en trait continu épais) la caractéristique spectrale de la tension U₊ représentative du courant de mode commun, lorsqu'un filtre 10 qui est conforme à la figure 1 est utilisé pour le même appareil électrique 30, à la place du filtre de la figure 2. Les valeurs de capacités qui sont utilisées dans ce filtre 10 non-conforme à l'invention sont les mêmes que précédemment. La valeur de l'inductance L1 est alors de 0,86 µH, pour une valeur totale d'inductance dans le filtre qui est égale à celle du filtre conforme à l'invention testé précédemment. Avec le filtre de la figure 1 (sans bobine L2), la caractéristique de la tension U₊ monte à 34 dBµV, c'est-à-dire 22 dBµV au-dessus de la limite qui est prescrite par la norme BMW Group Standard GS 95002-2 pour la fréquence 76 MHz. Le transfert d'une moitié (0,43 mH) de la valeur totale d'inductance de la liaison 11 à la liaison 12 permet donc de décaler le pic de résonance du courant de mode commun, de la valeur de fréquence de 73 MHz environ (courbe en trait continu épais de la figure 4a, relative au filtre de la figure 1, non-conforme à l'invention) à la valeur de fréquence de 20 MHz environ (courbe en trait continu fin de la figure 4a, relative au filtre de la figure 2, conforme à l'invention). Un intérêt particulier pour ce décalage de fréquence de résonance du courant de mode commun réside dans la valeur maximale qui est prescrite par la norme : 33 dBµV à 20 MHz au lieu de 12 dBµV à 80 MHz, et de l'importance de respecter cette norme pour la bande de fréquence 76-108 MHz, utilisée pour la réception FM.

Les figures 3b et 4b correspondent respectivement aux figures 3a et 4a lorsque le test du courant de mode commun est effectué sur la liaison 12. Le réseau de stabilisation d'impédance de ligne 40 est maintenant inséré entre le filtre 10 et la borne de sortie 22 de la batterie 20, sur la liaison 12. La résistance 41 est encore égale à 50 Ω et la tension électrique qui est mesurée dans la résistance 41 lorsque l'appareil 30 est alimenté en énergie électrique par la source 20, est notée U-. L'appareil électrique 30 est le même que pour les figures 3a et 4a, et le diagramme de la figure 4b reproduit l'analyse spectrale de 20· log₁₀(U-). Ce diagramme aboutit aux mêmes conclusions que celui de la figure 4a, pour prouver l'intérêt de l'invention.

En outre, le filtre qui vient d'être décrit est efficace simultanément pour réduire des courants de mode différentiel qui sont produits par l'appareil électrique 30 à travers la source de tension électrique 20.

L'efficacité du filtre de l'invention (figure 2) peut est accrue en rapprochant l'un de l'autre les emplacements d'implantation des deux bobines L1 et L2 sur la carte de circuit imprimé, afin qu'une interaction magnétique existe entre ces deux bobines. Eventuellement, les deux bobines L1 et L2 peuvent être disposées autour d'un noyau magnétique commun, pour augmenter encore cette interaction. De façon connue, une valeur d'inductance mutuelle non nulle intervient alors dans l'efficacité du filtre. Le signe, positif ou négatif, de cette valeur d'inductance mutuelle dépend des sens d'enroulement respectifs des deux bobines L1 et L2. L'efficacité du filtre conforme à l'invention est augmentée ou réduite en fonction de ce signe. Pour augmenter cette efficacité, la contribution du courant élémentaire de mode commun i_{C} qui circule dans la liaison 11, à la tension électrique qui existe entre les bornes de la bobine L2 par effet d'induction mutuelle, est en moyenne sur une durée suffisamment longue par rapport à la fréquence considérée, du même signe que la contribution par auto-induction du courant élémentaire de mode commun i_{C} qui circule dans la liaison 12. De même, la contribution du courant élémentaire de mode commun i_{C} qui circule dans la liaison 12, à la tension électrique qui existe entre les bornes de la bobine L1 par effet d'induction mutuelle, est en moyenne sur une durée suffisamment longue par rapport à la fréquence considérée, aussi du même signe que la contribution par auto-induction du courant élémentaire de mode commun i_{C} qui circule dans la liaison 11. A la lecture de cette description, l'Homme du métier saura sélectionner les sens d'enroulement des deux bobines L1 et L2 qui sont favorables pour augmenter l'efficacité du filtre.

## Revendications

1. Equipement électrique comprenant :
- un appareil électrique (30) ayant une première et une deuxième bornes d'alimentation électrique (31, 32), l'appareil électrique (30) comprenant un moteur sans balais ; et
- un filtre électrique (10) connecté entre une source de tension électrique (20) et l'appareil électrique (30), ledit filtre comprenant :
- une première liaison électrique (11) reliant une première borne de sortie (21) de la source (20) à la première borne d'alimentation électrique (31) de l'appareil (30), ladite première liaison comprenant une première bobine (L1) ;
- une seconde liaison électrique (12) reliant une seconde borne de sortie (22) de la source (20) à la seconde borne d'alimentation électrique (32) de l'appareil (30) ;
- un premier ensemble capacitif (13) connecté d'une part à la première liaison (11) entre la première bobine (L1) et la première borne d'alimentation électrique (31) de l'appareil (30), et connecté d'autre part à la seconde liaison (12) par un premier nœud (N1) ; et
- un second ensemble capacitif (14) connecté d'une part à la première liaison (11) entre la première borne de sortie (21) de la source (20) et la première bobine (L1), et connecté d'autre part à la seconde liaison (12) par un second nœud (N2), ledit premier nœud (N1) étant situé dans la seconde liaison électrique (12) entre ledit second nœud (N2) et la seconde borne d'alimentation électrique (32) de l'appareil (30) ;
ladite seconde liaison (12) comprenant au moins une seconde bobine (L2) située entre ledit premier nœud (N1) et ledit second nœud (N2),
les première (L1) et seconde (L2) bobines étant positionnées l'une par rapport à l'autre pour produire une interaction magnétique entre elles, et ont des sens d'enroulement respectifs tels que des courants électriques égaux et variables qui entrent dans la source (20) par les première (21) et seconde (22) bornes de sortie, un desdits courants séparément par chaque borne de sortie, produisent dans chacune des bobines (L1, L2) une contribution de tension par induction mutuelle et une contribution de tension par auto-induction qui ont un même signe pour ladite bobine, en moyenne pendant une durée d'utilisation du filtre,
la première bobine (L1) ayant une valeur d'inductance comprise entre 0,1 et 1µH,
un écart entre une valeur d'inductance de la première bobine (L1) et une valeur d'inductance de la seconde bobine (L2) étant inférieur ou égal à 20 %, les première (11) et seconde (12) liaisons électriques du filtre étant connectées une-à-une aux deux bornes d'alimentation électrique (31, 32) de l'appareil (30) de sorte que le premier ensemble capacitif (13) soit connecté électriquement en parallèle avec l'appareil entre lesdites deux bornes d'alimentation électrique de l'appareil.

2. Equipement électrique selon la revendication 1, dans lequel le premier ensemble capacitif (13) comprend au moins un condensateur (C30-32).

3. Equipement électrique selon la revendication 1 ou 2, dans lequel le second ensemble capacitif (14) comprend au moins un autre condensateur (C33).

4. Equipement électrique selon l'une quelconque des revendications précédentes, dans lequel les première (L1) et seconde (L2) bobines sont couplées, et dans lequel l'une desdites première et seconde bobines est bobinée dans le sens horaire, et l'autre desdites première et seconde bobines est bobinée dans le sens antihoraire.

5. Equipement électrique selon l'une quelconque des revendications précédentes, dans lequel la seconde bobine (L2) a une valeur d'inductance comprise entre 0,1 et 1µH.

6. Equipement électrique selon l'une quelconque des revendications précédentes, dans lequel :
- le premier ensemble capacitif (13) a une valeur de capacité comprise entre 300 et 3000 µF ; et
- le second ensemble capacitif (14) a une valeur de capacité comprise entre 100 et 1000 µF.

7. Equipement selon l'une des revendications précédentes, dans lequel l'appareil électrique comprend un groupe moto-ventilateur.

8. Equipement selon l'une quelconque des revendications précédentes, formant un système de chauffage, ventilation et conditionnement d'air pour un habitacle de véhicule, et l'appareil électrique comprend un moteur agencé pour la ventilation de l'habitacle.

## Patentansprüche

1. Elektrische Ausrüstung, umfassend:
- ein elektrisches Gerät (30), das eine erste und eine zweite Stromanschlussklemme (31, 32) aufweist, wobei das elektrische Gerät (30) einen bürstenlosen Motor aufweist; und
- einen elektrischen Filter (10), der zwischen einer elektrischen Spannungsquelle (20) und dem elektrischen Gerät (30) angeschlossen ist, wobei der Filter aufweist:
- eine erste elektrische Verbindung (11), die eine erste Ausgangsklemme (21) der Quelle (20) mit der ersten Stromanschlussklemme (31) des Gerätes (30) verbindet, wobei die erste Verbindung eine erste Spule (L1) aufweist;
- eine zweite elektrische Verbindung (12), die eine zweite Ausgangsklemme (22) der Quelle (20) mit der zweiten Stromanschlussklemme (32) des Gerätes (30) verbindet;
- eine erste kapazitive Anordnung (13), die einerseits an der ersten Verbindung (11) zwischen der ersten Spule (L1) und der ersten Stromanschlussklemme (31) des Gerätes (30) angeschlossen ist, und die andererseits an der zweiten Verbindung (12) durch einen ersten Knoten (N1) angeschlossen ist; und
- eine zweite kapazitive Anordnung (14), die einerseits an der ersten Verbindung (11) zwischen der ersten Ausgangsklemme (21) der Quelle (20) und der ersten Spule (L1) angeschlossen ist, und die andererseits an der zweiten Verbindung (12) durch einen zweiten Knoten (N2) angeschlossen ist, wobei sich der erste Knoten (N1) in der zweiten elektrischen Verbindung (12) zwischen dem zweiten Knoten (N2) und der zweiten Stromanschlussklemme (32) des Gerätes (30) befindet;
wobei die zweite Verbindung (12) mindestens eine zweite Spule (L2) aufweist, die sich zwischen dem ersten Knoten (N1) und dem zweiten Knoten (N2) befindet,
wobei die erste (L1) und die zweite (L2) Spule relativ zueinander so positioniert sind, um eine magnetische Wechselwirkung zwischen sich zu erzeugen, und jeweilige Wickelrichtungen aufweisen, die derart sind, dass gleiche und variable elektrische Ströme, die durch die erste (21) und zweite (22) Ausgangsklemme, jeweils einer der Ströme getrennt durch jede Ausgangsklemme, in die Quelle (20) eintreten, in jeder der Spulen (L1, L2) einen Spannungsbeitrag durch gegenseitige Induktion und einen Spannungsbeitrag durch Selbstinduktion, die für die Spule ein gleiches Vorzeichen aufweisen, im Durchschnitt während einer Nutzungsdauer des Filters erzeugen,
wobei die erste Spule (L1) einen Induktivitätswert zwischen 0,1 und 1 µH aufweist,
wobei eine Abweichung zwischen einem Induktivitätswert der ersten Spule (L1) und einem Induktivitätswert der zweiten Spule (L2) weniger als oder gleich 20 % beträgt,
wobei die erste (11) und zweite (12) Verbindung eine nach der anderen an die zwei Stromanschlussklemmen (31, 32) des Gerätes (30) derart angeschlossen sind, dass die erste kapazitive Anordnung (13) mit dem Gerät zwischen den zwei Stromanschlussklemmen des Gerätes elektrisch parallel geschaltet ist.

2. Elektrische Ausrüstung nach Anspruch 1, wobei die erste kapazitive Anordnung (13) mindestens einen Kondensator (C30-32) aufweist.

3. Elektrische Ausrüstung nach Anspruch 1 oder 2, wobei die zweite kapazitive Anordnung (14) mindestens einen anderen Kondensator (C33) aufweist.

4. Elektrische Ausrüstung nach einem der vorhergehenden Ansprüche, wobei die erste (L1) und die zweite (L2) Spule verbunden sind, und wobei eine der ersten und der zweiten Spule im Uhrzeigersinn gewickelt ist und die andere der ersten und der zweiten Spule gegen den Uhrzeigersinn gewickelt ist.

5. Elektrische Ausrüstung nach einem der vorhergehenden Ansprüche, wobei die zweite Spule (L2) einen Induktivitätswert zwischen 0,1 und 1 µH aufweist.

6. Elektrische Ausrüstung nach einem der vorhergehenden Ansprüche, wobei:
- die erste kapazitive Anordnung (13) einen Kapazitätswert zwischen 300 und 3.000 µF aufweist; und
- die zweite kapazitive Anordnung (14) einen Kapazitätswert zwischen 100 und 1.000 µF aufweist.

7. Elektrische Ausrüstung nach einem der vorhergehenden Ansprüche, wobei das elektrische Gerät eine Motorventilator-Gruppe aufweist.

8. Elektrische Ausrüstung nach einem der vorhergehenden Ansprüche, die ein Heizungs-, Lüftungs- und Klimatisierungssystem für einen Fahrgastraum eines Kraftfahrzeugs bildet, und das elektrische Gerät weist einen Motor auf, der für die Belüftung des Fahrgastraums ausgebildet ist

## Claims

1. Electrical equipment comprising:
- an electrical device (30) having a first and a second electrical supply terminal (31, 32), the electrical device (30) comprising a brushless motor; and
- an electrical filter (10) connected between an electrical voltage source (20) and the electrical device (30), said filter comprising:
- a first electrical connection (11) connecting a first output terminal (21) of the source (20) to the first electrical supply terminal (31) of the device (30), said first connection comprising a first coil (L1);
- a second electrical connection (12) connecting a second output terminal (22) of the source (20) to the second electrical supply terminal (32) of the device (30);
- a first capacitive assembly (13) connected firstly to the first connection (11) between the first coil (L1) and the first electrical supply terminal (31) of the device (30), and connected secondly to the second connection (12) via a first node (N1); and
- a second capacitive assembly (14) connected firstly to the first connection (11) between the first output terminal (21) of the source (20) and the first coil (L1), and connected secondly to the second connection (12) by a second node (N2), said first node (N1) being located in the second electrical connection (12) between said second node (N2) and the second electrical supply terminal (32) of the device (30);
said second connection (12) comprising at least a second coil (L2) located between said first node (N1) and said second node (N2),
the first (L1) and second (L2) coils being positioned with respect to one another in order to produce a magnetic interaction therebetween, and have respective winding directions such that equal and variable electric currents which enter the source (20) via the first (21) and second (22) output terminals, one of said currents separately via each output terminal, produce in each of the coils (L1, L2) a voltage contribution by mutual induction and a voltage contribution by self-induction which have a same sign for said coil, on average for a duration of use of the filter,
the first coil (L1) having an inductance value between 0.1 and 1µH,
a difference between an inductance value of the first coil (L1) and an inductance value of the second coil (L2) being less than or equal to 20%,
the first (11) and second (12) electrical connections of the filter being connected one-by-one to the two electrical supply terminals (31, 32) of the device (30) such that the first capacitive assembly (13) is connected electrically in parallel with the device between said two electrical supply terminals of the device.

2. Electrical equipment according to Claim 1, wherein the first capacitive assembly (13) comprises at least one capacitor (C30-32).

3. Electrical equipment according to Claim 1 or 2, wherein the second capacitive assembly (14) comprises at least another capacitor (C33).

4. Electrical equipment according to any one of the preceding claims, wherein the first (L1) and second (L2) coils are coupled, and wherein one of said first and second coils is coiled in the clockwise direction, and the other of said first and second coils is coiled in the anticlockwise direction.

5. Electrical equipment according to any one of the preceding claims, wherein the second coil (L2) has an inductance value between 0.1 and 1 µH.

6. Electrical equipment according to any one of the preceding claims, wherein:
- the first capacitive assembly (13) has a capacitance value between 300 and 3000 µF; and
- the second capacitive assembly (14) has a capacitance value between 100 and 1000 µF.

7. Equipment according to one of the preceding claims, wherein the electrical device comprises a motorized fan unit.

8. Equipment according to any one of the preceding claims, forming a heating, ventilation and air conditioning system for a vehicle interior, and the electrical device comprises a motor arranged to ventilate the interior.
